(19) Europäisches Patentamt / European Patent Office / Office européen des brevets

(11) **EP 3 989 360 A1**

(12) **EUROPEAN PATENT APPLICATION**
published in accordance with Art. 153(4) EPC

(43) Date of publication:
**27.04.2022 Bulletin 2022/17**

(51) International Patent Classification (IPC):
***H01Q 3/42*** (2006.01)

(21) Application number: **19935210.5**

(52) Cooperative Patent Classification (CPC):
**H01Q 3/42**

(22) Date of filing: **24.06.2019**

(86) International application number:
**PCT/RU2019/000450**

(87) International publication number:
**WO 2020/263111 (30.12.2020 Gazette 2020/53)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(71) Applicant: **OBSCHESTVO S OGRANICHENNOY OTVETSTVENNOSTIYU "GIDROMARINN"**
**Moscow, 143026 (RU)**

(72) Inventors:
• **VOLOSHCHENKO, Vadim Yurievich**
  **Rostovskaya obl., 347935 (RU)**

• **PLESHKOV, Anton Yurievich**
  **Tomskaya obl. 636000 (RU)**
• **TARASOV, Sergey Pavlovich**
  **Rostovskaya obl., 347939 (RU)**
• **VORONIN, Vasiliy Alekseevich**
  **Rostovskaya obl., 347932 (RU)**
• **PIVNEV, Petr Petrovich**
  **Rostovskaya obl., 347923 (RU)**
• **VOLOSHCHENKO, Aleksandr Petrovich**
  **Rostovskaya obl., 347900 (RU)**

(74) Representative: **Jeck, Anton**
  **Jeck, Fleck & Partner mbB**
  **Patentanwälte**
  **Klingengasse 2**
  **71665 Vaihingen/Enz (DE)**

(54) **METHOD AND DEVICE FOR INCREASING THE EFFICIENCY OF AN EMITTING ANTENNA**

(57) The invention relates to hydroacoustic domain, notably to methods and devices of active location.

The method of controlling intercarrier frequency wave efficiency with parametric radiating antenna is based on placing electroacoustic transducer with piezoelement with given resonance frequency $(f_1 + f_2)/2 = f_0$ and pass band corresponding to intercarrier frequency wave diapason in locating area, feeding electric signals from radiating tract output to electroacoustic transducer piezoelement, forming in locating area spatial area of collinear distribution and non-linear interaction of intense ultrasound pimp waves, generation of intercarrier frequency wave with cyclic frequency $\Omega = 2\pi | f_1 - f_2 |$. New features are the following: multicomponent excitation signal if formed due to generating in radiating tract $N$ oscillations with similar amplitude and with similar initial phase at the period of time $t = 0$), with frequencies $\omega_\nu$, sequentially differing from each other by $\Omega = 2\pi F\_$ and situated in pass band of piezoelement and coming from radiating tract output to piezoelement with resonance cyclic frequency $\omega_0 = 2\pi f_0$ electric multicomponent signal of escitation, presented as sum of $N$ oscillations and regulation of generation efficiency and adjusting of field parameters $(N - 1)$ of intercarrier frequency component wave with cyclical frequencies $\Omega$, $2\Omega$, ...., $(N - 1)\Omega$ formed by parametric radiating antenna, implemented by switching off of antiphase switching on of given constituents set. The method is implemented due to the device that includes reference generator, delayed pulse-shaping circuit, $(N - 1)$ coincidence circuit, $N$ frequency dividers, analog switch, adder, amplitude modulator, impulse generator, power amplifier, electroacoustic transducer, controlling and adjustment unit.

2 independent formula points, 7 dependent formula points, 13 illustrations.

EP 3 989 360 A1

**Description**

The invention relates to hydroacoustic domain, notably to methods and devices of active location that allows to form in hydroacoustic channel low-frequency ultrasonic radiation in a fixed solid angle, in particular using parametric radiation mode (PRM).

**BACKGROUND OF THE INVENTION**

Low-frequency signal generation and its transmission are complicated issue in both scientific and technical spheres, because interference antenna efficiency depends on its waves size which should be huge. Consequently, hydroacoustic interference antennae must be of significant weight and dimensional parameters to perform directional radiation at frequencies of units to dozens Hz.

Parametric radiating antenna (PRA) doesn't have such disadvantage (see Hydroacoustics over 20 years (based on the 80th meeting of the Acoustical Society of America). Edited by (see Hydroacoustic over 20 years (based on materials of 80-anniversary of Acoustic society of the USA), Edited by Y.F. Tarasyuk, Leningrad, Shipbuilding, 1975, p. 176, chapter 4. Naval hydroacoustic antennae, §17. New fields of low-frequency hydroacoustic emitters research, pp. 161-167) its operation is based on non-linear interaction of ultrasonic waves with finite amplitude, i.e. excitation with frequencies $f_1, f_2$, that form hydrodynamic disturbances of combination frequencies, specifically, intercarrier frequency wave (IFW) $F = |f_1 - f_2|$, when spreading in real aquatic environment that has non-linearity of elastic properties. However, efficiency increasing of pump waves "energetic transfer" in IFW is still an issue if the day as non-linear phenomena are secondary effects. Amplitudes' special distribution of sound pressure in IFW, that is formed in PRM interaction zone, is defined by both parameters of propagation medium (non-linear parameter $\varepsilon$, density $\rho_0$, sound velocity $c_0$, pump waves attenuation constant $\alpha_0$ and IFW$^{\alpha_-}$) and parameters of electroacoustic transducer (EAT) (sound pressure amplitude $p_{01}, p_{02}$ with frequencies $f_1, f_2$ by the EA surface, its passband, i.e. cyclical IFW value $\Omega = 2\pi |f_1 - f_2|$ and IFW diffraction distance $L\mathcal{A}$). Moreover, if IFW sound pressure amplitudes value is directly proportional to non-linear parameter value and to EAT parameters, density and sound velocity are inversely related. In this regard, there are some methods to increase the effectiveness of forming IFW in PRA:

> 1) increase sound pressure amplitudes of pump waves at expense of artificial change of interaction zone geometrical parameters;
> 2) filling the non-linear interaction zone of finite amplitude ultrasound waves with solid or liquid intervening medium, which, in comparison to water, has increased value of non-linear parameter and ultrasonic velocity dispersion;
> 3) choice of modulation type and corresponding schemes of electrical signal forming in emitting tract to excite EAT. It is important to note, that the first two methods can be used in sphere of hydroacoustic pool or polygon measurements, but it is limited in designing of active location hydroacoustic systems antenna constructions that are placed on portable devices; the third method is universal.

Nevertheless, today it is not known clearly whether technical abilities of hydroacoustic devices with PRA for IFW can allow the performance of both generation efficiency control and low-frequency IFW forming ultrasound field parameters correction due to the application of multicomponent phase-connected signals of excitation in schemes of forming.

Technical abilities provide the method to increase the effectiveness of forming IFW in PRA due to «managing» quadratic non-linearity of propagation medium by placing discretely-stratified substantial medium in linear interaction zone (see "Non-linear interactions in laminate inhomogeneous mediums", Zagrai N.P., Taganrog, 1998, pp. 36-55, 111-217) The same source gives an information on the devise for the method implication, that has two electric signals generators with frequencies $f_1$ and $f_2$ ($f_1 < f_0 < f_2$ И ($f_1 + f_2$)/2 = $f_0$) and consequently connected through linear adder impulse modulator, control input of which is connected with impulse generator output, power amplifier, notch filter and EAT with piezoelement and also shielding, hydro, electro and noise reduction elements, piezoelement of which oscillates on the main thickness mode (resonance frequency $f_0$) in the operation of one-sided piston radiation into locating medium; it also has a system of $m$ discrete plane-parallel layers of substances in non-linear interaction zone located perpendicularly in relation to pump waves spreading direction.

Described method is performed as follows:

- EAT with piezoelement and also shielding, hydro, electro and noise reduction elements is placed so that his acoustic axe was pointed in a given direction;
- EAT works due to using reverse piezoelectric effect that is reflected in pezoelement deformation that occurs under the impact of attached to it alternating-current electric field;

- Piezoelement itself has simple geometric form (bar, plate or disk) with given resonance frequency $f_0$ and disposition of solid electrodes ("signal", "general");
- To the surface of piezoelement solid "signal" electrode with resonance frequency $f_0$ from the output of radiating tract an electric two-component excitation signal as two generators oscillation beats with frequencies $f_1$ and $f_2$, amplitudes of which are changing in accordance with the harmonic law, is fed;
- A mode of oscillations' one-sided transition is performed into locating environment for piezoelement and, consequently, amplitude piston (steady) distribution of its radiating surface i.e. of solid "common" electrode happens and due to the power transmission by medium particles, spreading of ultrasound waves with angular frequencies $\omega_1 = 2\pi f_1, \omega_2 = 2\pi f_2$ and wave vectors $\vec{k}_1, \vec{k}_2$ is performed;
- In locating environment mutual spatial domain of both collinear propagation and non-linear interaction of intense ultrasound waves with frequencies $f_1$ and $f_2$, including near (still flat wave surfaces) and far (spherical wave surfaces already) fields of formed PRA is shaped;
- Due to the quadratic nonlinearity of propagation medium and according time and spatial coordination of intense ultrasound waves spectral components of combination frequencies are generated; it meets synchronism conditions $\omega_2 \pm \omega_1 = \omega_3$ and $\vec{k}_2 \pm \vec{k}_1 = \vec{k}_3$ (e.g. high-frequency wave corresponds to "+" and IFW corresponds to "-"; $\vec{k}_1, \vec{k}_2, \vec{k}_3$ correspond to wave vectors of interacting ultrasound waves and of combination frequencies waves relatively);
- Within EAT piezoelement pass band values of frequencies $f_1$ and $f_2$ of generators' electric signals and accordingly radiating tract output signal parameters are rearranged along with providing the IFW generation $\Omega = 2\pi(f_2 - f_1)$ in required frequencies' domain;
- Set of discrete homogenous substances (1,2,3, $m$), forming multilayer system of different mediums is laced in the field of non-linear interaction in direction from EAT;
- Different wave resonance thicknesses and combinations of its physical parameters (density $\rho_m$, sound velocity $c_m$, non-linear parameter $\varepsilon_m$), located perpendicularly in relation to ultrasound pump waves distribution, are selected for a system of $m$ discrete plane-parallel substances layers in the area of non-linear interaction, which allows them to be considered as a set of non-linear acoustic resonators, influencing non-linear phenomena;
- Given increase of non-linear interaction effectiveness is performed due to «managing» quadratic non-linearity of propagation medium, in particular, IFW generation. General formula for amplitude of forming IFW field with discretely-stratified substantial medium in the area of non-linear interaction is the following:

$$A_- = \sum_{i=1}^{m} (- \varepsilon_i \Omega^2 / \rho_{0i} c_{0i}^4) \times (e^{-jk_i R_0} / 4\pi R_0) \times D_{ti} \times D_{li}$$

, (1),

where $D_{ti}$, $D_{li}$ stands for transverse and lateral aperture multipliers in every $i$ layer, $R_0$ is varying vector module that connects the origin of coordinates $(x,y,z)$, located inside of non-linear interaction area with very remote view-point $(x',y',z')$.

Nevertheless, the described above method of increasing EAT IFW generation effectiveness due to «managing» quadratic non-linearity of propagation medium by placing discretely-stratified substantial medium in linear interaction zone has some disadvantages:

1) Presence of sequence of $m$ discrete homogenous substances layers with resonance thicknesses in the area of non-linear interaction leads to decrease of resulting pass band of laminate spatial structure which results in decrease in broadbandness mode of IFW parametric radiation, caused by corresponding pump waves frequencies $f_1, f_2$ change, which cuts down practical applicability of the method when constructing hydroacoustic antenna systems;

2) To generate intercarrier frequency waves in the area of non-linear interaction it is necessary to meet synchronism conditions for excitation signals, i.e. compliance with time and spatial coordination inside of PRA volume. Besides, presence of different substantial mediums in the area of non-linear interaction of multilayer systems, physical parameters of which are changed abruptly, distorts phasing of continually generating spectral components, decreasing the possibility of the method's feasibility;

3) EAT with set of discrete homogenous substance layers (1,2,3, $m$) with resonance thicknesses which form multilayer system of different mediums in adjacent area of PRA non-linear interaction cannot effectively function in terms of receiving detected objects echo signals;

4) As shown in point (1), amplitude of IFW forming field with discretely-stratified substantial medium in the area of non-linear interaction is directly proportional to cyclic IFW square $\Omega = 2\pi |f_1 - f_2|$ which implies that the effectiveness of PRA for parametric radiation mode in low frequency band significantly decreases;

5) Difficulties for IFW in the device executing the method described above to control generation effectiveness and promptly correct ultrasound field parameters forming due to implication of two-components excitation signal occurs.

The reason of difficulties in achieving claimed technical result is in absent of the possibility for IFW PRA to control generation effectiveness and correct forming ultrasound field parameters due to the implication of multi-components phase-connected excitation signals in schemes of forming.

Features matching claimed method:

- EAT with piezoelement and also shielding, hydro, electro and noise reduction elements is placed in locating area;
- Piezoelement itself has simple geometric form (bar, plate or disk) with given resonance frequency $f_0$ and disposition of solid electrodes ("signal", "general");
- To the surface of piezoelement solid "signal" electrode with resonance frequency $f_0$ from the output of radiating tract electric excitation signals, amplitudes of which are changing in accordance with the harmonic law and frequencies' values are located in piezoelement pass band are fed;
- A mode of oscillations' one-sided transition is performed into locating environment for piezoelement and, consequently, amplitude piston (steady) distribution of its radiating surface is provided along with spreading of intense ultrasound waves due to energy medium transition to particles;
- In locating environment mutual spatial domain of both collinear propagation and non-linear interaction of intense ultrasound waves with frequencies $f_1$ and $f_2$, including near (still flat wave surfaces) and far (spherical wave surfaces already) fields of formed PRA is shaped;

There is known method of controlling PRA IFW generation effectiveness due to forming saturated with gas-vapor bubbles medium that has increased non-linearity along with velocity dispersion in non-collinear propagation area and non-linear interaction of excitation waves (see pat. The USA 6704247 High efficiency parametric sonar, G01S 15/00, G01S 7/52, publ. 9. 03. 2004). This patent deals with the device carrying out method that also comprises two electric signals generators with frequencies $f_1$ and $f_2$ ($f_1 < f_0 < f_2$ and $(f_1 + f_2)/2 = f_0$) sequentially connected with linear adder, impulse modulator, controlling input of which is connected with impulse generator output, power amplifier, notch filter and two EAT each having piezoelement, shielding, hydro, electro and noise reduction elements and also additional radiating tract comprising consistently connected high frequency generator, power amplifier and the third high frequency EAT that also has piezoelement and shielding, hydro, electro and noise reduction elements that works continually forming saturated with gas-vapor bubbles medium in non-collinear propagation area and non-linear interaction of excitation waves due to cavity.

## SUMMARY OF THE INVENTION

The method described in the patent is carried out in the following way:

- Two similar EAT are placed next to each other in locating medium in elevation plane, both are equipped with piezoelement and shielding, hydro, electro and noise reduction elements so that intersection of their acoustic axes is acute angle $\beta$ and their acoustic axes projections to azimuth plane have the same direction;
- Piezoelement itself has simple geometric form (bar, plate or disk) with given resonance frequency $f_0$ and solid electrodes ("signal", "general");
- To the surfaces of both piezoelements solid "signal" electrode with resonance frequency $f_0$ from the output of radiating tract, electric excitation signal, for instance, two-components with frequencies $f_1$ and $f_2$, amplitudes of which are changing in accordance with the harmonic law is fed;
- A mode of oscillations' one-sided transition is performed into locating environment for both piezoelements and, consequently, amplitude piston (steady) distribution of its radiating surface, i.e. of solid "mutual" electrode, which causes ultrasound waves with cyclic frequencies $\omega_1 = 2\pi f_1$, $\omega_2 = 2\pi f_2$ and wave vectors $\vec{k}_1$, $\vec{k}_2$ due to energy medium transition to particles;
- Mutual spatial domain of both non-collinear propagation and non-linear interaction of two waves is formed in locating area, for example, with cyclic frequencies $\omega_1 = 2\pi f_1$, $\omega_2 = 2\pi f_2$ and wave vectors $\vec{k}_1, \vec{k}_2$ having complicated double-beam crossed shape, including near (still flat wave surfaces) and far (spherical wave surfaces already) fields of formed PRA;
- Spectral components of combination frequencies are generated due to the quadratic nonlinearity of propagation medium and according time and spatial coordination of intense ultrasound waves; these components meet synchronism conditions $\omega_2 \pm \omega_1 = \omega_3$ and $\vec{k}_2 \pm \vec{k}_1 = \vec{k}_3$ (e.g. high-frequency wave corresponds to "+" and IFW corresponds

to "-"; $\vec{k}_1, \vec{k}_2, \vec{k}_3$ correspond to wave vectors of interacting ultrasound waves and of combination frequencies waves relatively);

- The third high frequency EAT with acoustic axe in the middle of non-collinear propagation and non-linear interaction area is located in medium under non-collinear propagation and non-linear interaction are of two waves with frequencies $\omega_1 = 2\pi f_1$, $\omega_2 = 2\pi f_2$ and wave vectors $\vec{k}_1, \vec{k}_2$;
- Saturated with gas-vapor medium is created in non-collinear propagation and non-linear interaction are of two waves due to upward radiation of continuous ultrasound signal by the third EAT in cavity mode and allowing to change IFW generation efficiency.

Principle of analogue functioning is defined by the process of IFW generation in liquid with gas bubbles with radius $R$ under non-linear interaction of two pump waves with cyclic frequencies $\omega_1 = 2\pi f_1$, $\omega_2 = 2\pi f_2$ and amplitudes of sound pressure $p_{01}$, $p_{02}$ of pump waves by EAT surface. In case of $\Omega << \omega_1, \omega_2$, resonance bubbles' density proximities are $n(R_{\omega 1}) \approx n(R_{\omega 2}) = n(R_{\omega 0})$ for pump waves ($\omega_0 = (\omega_1 + \omega_2)/2$) and under the condition $\Omega/\omega_0 << Q^{-1}$ (where $Q$ stands for bubble quality), non-linearity of medium parameter $\varepsilon$ is calculated with relation (see Kobelev Y.A., Ostrovskiy L.A. Gas-fluid models as of non-linear detergent medium, Gorkiy, USSR, 1980, pp. 143-160) $\varepsilon \approx 3{,}93 \times 10^{-2} \times n(R_{\omega 0}) \times Q \times \lambda^4$ (2), where $\lambda$ is wave length at frequency $\omega_{0,8}$. Axial distribution of IFW sound pressure amplitude, formed after passing pump waves through bubble layer with L layer in non-linear interaction is described with the following relation:

$$P_- \approx \frac{\varepsilon \Omega^2 p_{01} p_{02} S}{8\pi \rho_0 c_0^4 \alpha r}(1 - e^{-2\alpha L})$$

(3), where $S$ is radiator area, $r$ is a distance to hydrophone,

$$\alpha = 725 \times n(R_{\omega 0}) \times R_{\omega 0}^3$$

is wave attenuation coefficient with cyclic frequency $\omega_0$, $R_{\omega 0}$ is bubbles' radii with resonance frequency equal to $\omega_0$.

However, EAT efficiency increase method due to forming saturated with gas-vapor bubbles medium described above has disadvantages:

1) Method workability is limited by lack of possibility to change positional relationship of two similar EATs in elevation plane which leads to inability to regulate both length and width of mutual intersection area and non-linear interaction of intense ultrasound pump waves, that gets to the area saturated with gas-vapor bubbles;
2) Method practical implementation is difficult because there are almost always resonance bubbles in real system, which influence both non-linearity and energy dissipation, distorting phasing of continuously generated spectral components;
3) Area of non-collinear propagation and non-linear interaction, described in the method, has complicated double-beam crossed shape, resulting directional characteristic (DC) of PRA can have trilobate main lobe of DC (two lobes directed to distribution of two power monochromatic pump signals with frequencies $f_1, f_2$ that make up acute angle in relation to each other which can result in angular data at target detecting being ambiguous) 4) This method elaborates synthesis of only lateral component of special structure PRA field while transverse (border) effects are not taken into account, in particular, influence of different transverse shifting amplitude distribution over the surface of EAT piezoelement, radiating two power monochromatic pump signals with frequencies $f_1, f_2$.

The reason obstructing achieving of claimed technical result is in a lack of possibility for IFW PRA to control generation effectiveness and to correct forming ultrasound field parameters due to implication of multicomponent phase-connected pump signals in PRA forming schemes.

Features matching claimed method:

- EAT with piezoelement and also shielding, hydro, electro and noise reduction elements is placed in locating area so that its acoustic axe in the space is directed in given coordinates;
- To the surfaces of piezoelement solid "signal" electrode with resonance frequency $f_0$ from the output of radiating tract electric excitation signals, amplitudes of which are changing in accordance with the harmonic law and frequencies' values are in piezoelement pass band are fed;
- A mode of oscillations' one-sided transition is performed into locating environment for piezoelement and, consequently, piston (steady) distribution of its radiating surface displacement amplitude, i.e. of solid "mutual" electrode;

- Mutual spatial domain of both non-collinear propagation and non-linear interaction of intense ultrasound waves with frequencies $f_1$ and $f_2$ is formed in locating area, including near (still flat wave surfaces) and far (spherical wave surfaces already) fields of formed PRA;
- New spectral components, waves of combination frequencies meeting synchronism conditions $\omega_2 \pm \omega_1 = \omega_3$ and $\vec{k}_2 \pm \vec{k}_1 = \vec{k}_3$ (e.g. high-frequency wave corresponds to "+" and IFW corresponds to "-"; $\vec{k}_1, \vec{k}_2, \vec{k}_3$ correspond to wave vectors of interacting ultrasound waves and of combination frequencies waves relatively) are generated due to the quadratic nonlinearity of propagation medium and according time and spatial coordination of intense ultrasound waves.

The closest analogue to claimed method is method of IFW PRA generation efficiency improvement on account of using of three-component (amplitude-modulated) pump wave (see Novikov B.K., Rudenko O.V., Timoshenko V.I., Non-linear hydroacoustic, Leningrad, Shipbuilding, 1981. § 10.1. Signals forming schemes, pp. 138-154) distributing in non-linear interaction area. The same source describes the device that implements this method; the device comprises electric oscillation generators of high frequency $f$ and modulation frequency $F$ outputs of which are consistently connected via amplitude modulator, impulse modulator, controlling input if which is connected with impulse generator output, power amplifier, notch filter and EAT equipped with piezoelement and shielding, hydro, electro and noise reduction elements and piezoelement oscillating on the main thickness mode (resonance frequency $f_0$) in mode of one-sided piston radiation in locating area.

This method is based on the following:

- Electroacoustic transducer with pezoelement of given resonance frequency $(f_1 + f_2)/2 = f_0$ and pass band corresponding to intercarrier frequency wave diapason are placed in locating area;
- Electric signals with amplitudes changing in accordance with the harmonic law and oscillations' frequencies values $f_1$, $f_2$ are located in piezoelement pass band are fed to electroacoustic transducer piezoelement from radiating tract output;
- Spatial area of collinear distribution and non-linear interaction of intense ultrasound pump waves is formed in locating area, including near and far areas of formed parametric radiating antenna;
- The first low-frequency IFW harmonic with frequency $F$ correlating with modulation frequency is generated due to quadratic non-linearity of propagation medium.

Solid harmonic amplitude modulation signal is following;

$$U = U_m \cos 2\pi f t + \frac{m}{2} U_m \cos 2\pi (f + F)t + \frac{m}{2} U_m \cos 2\pi (f - F)t, (4)$$

Where $U$ and $U_m$ is for instantaneous amplitude value of electric signal, $m$ is modulation coefficient and maximum possible value of side spectral components at $0 \leq m \leq 1$ is $U_m/2$ and phases are symmetrical in relation to carrier frequency phase, $f$ is carrier frequency, $F$ is modulation frequency, $(f_1 + f_2)/2 = f_0$. Parametric radiation mode at such settings of forming allows to generate sound pressure amplitude value of the first low-frequency IFW harmonic that is 3 dB higher than at any other forming settings. Mean power $M_{aver}$ at IFW component is 33% of peak power $M_{peak}$ of solid signal.

However, this method of PRA efficiency improvement on account of using amplitude modulated (AM) pump wave has certain disadvantages:

1) To manufacture PRA with three-component (amplitude-modulated) pump wave, pass band of electric tract and EAT must be equal to doubled modulated oscillation frequency, which creates certain difficulties in making electronic shapers and antenna system construction;

2) Implementation of driver circuit with amplitude-modulated oscillations (AMO) involves high level of the second low-frequency harmonic generation with frequency $2F$ which is formed in aquatic environment under two side components interaction;

3) PRA efficiency if lowered due to stray generation of the second IFW low frequency harmonic with frequency 2F amplitude of which at hundred-percent modulation ($m=1$) differs from the first IWF low frequency harmonic amplitude by only $m/2$;

4) Method of PRA efficiency improvements on account of using AM driver circuit is limited in controlling PRA efficiency and prompt correction of low-frequency IFW ultrasound forming field, at non-linear interaction of three discrete spectral pump components with frequencies $f_1 = f_0 - F, f_2 = f_0 + F, f_0 = (f_1 + f_2)/2$ both account of phase relation influence and analysis of PRA efficiency improvement on account of using multicomponent pumping signal are absent.

The reason obstructing achieving of claimed technical result is in a lack of possibility for IFW PRA to control PRA effectiveness and to correct forming ultrasound field parameters due to implication of multicomponent pumping signal in PRA forming schemes.

Features matching claimed method:

- Electroacoustic transducer with piezoelement with given resonance frequency $(f_1 + f_2)/2 = f_0$ and pass band corresponding to IFW diapason in locating area;
- Electric signals with amplitudes changing according to the harmonic law and oscillation frequency values $f_1, f_2$ are in piezoelement pass band are fed to electroacoustic transducer piezoelement from radiating tract output;
- Spatial domain of both collinear propagation and non-linear interaction of intense ultrasound pump waves is formed in locating area, including near and far fields of formed PRA;
- IFW with cyclical frequency $\Omega = 2\pi |f_1 - f_2|$ is formed.

The main task of the device is to improve performance of hydroacoustic equipment with parametric radiation mode (PRM).

Technical result is in efficiency improvement on account of providing a possibility to control IFW generation by PRA and to correct forming ultrasound field parameters.

Claimed result is obtained be the following actions:

- Electroacoustic transducer with piezoelement with given resonance frequency $(f_1 + f_2)/2 = f_0$ and pass band corresponding to IFW diapason is placed in locating area;
- Electric signals with amplitudes changing according to the harmonic law and oscillation frequency values $f_1, f_2$ are in piezoelement pass band are fed to electroacoustic transducer piezoelement from radiating tract output;
- Spatial domain of both collinear propagation and non-linear interaction of intense ultrasound pump waves is formed in locating area, including near and far fields of formed PRA;
- IFW with cyclical frequency $\Omega = 2\pi |f_1 - f_2|$ is formed;
- Multi-component oscillation signal if formed additionally, by generating in radiating tract $N$ of oscillations with similar amplitude and with similar initial phase at the moment of time $t = 0$) with frequencies $\omega_v$ that sequentially differ from each other by $\Omega = 2\pi F$_located in piezoelement pass band;
- Electrical multicomponent excitation signal presented as $N$ sum of oscillations is fed to piezoelement with resonance cyclic frequency $\omega_0 = 2\pi f_0$ from radiating tract output; this signal is defined by formula

$$S(t) = \sum_{v=0}^{N-1} \sin(\omega_1 + v\Omega)t = N[\sin(N\Omega t/2)/N\sin(\Omega t/2)]\sin\omega_m t$$

(5),

where $\omega_m = \omega_1 + (N - 1)\Omega/2$ is average excitation frequency, $t = 2\pi/N\Omega = 1/NF$_ is period $t$, necessary for forming of signal $S(t)$.

- Spatial domain of both collinear propagation and non-linear interaction of intense $N$-component ultrasound pump waves is formed in locating area, including near and far fields of formed PRA;
- In PRA $(N - 1)$-component IFW with cyclical frequencies $\Omega$, $2\Omega$, ...., $(N - 1)\Omega$ defined by non-linear interactions in propagation medium of given quantity of $N$ pump waves with cyclical frequencies $\omega_0$ spectral components, $\omega_1 = \omega_0 + \Omega$, $\omega_2 = \omega_0 + 2\Omega$,... $\omega_v = \omega_0 + N\Omega$ is generated;
- Adjustment of generation efficiency and correction of parameters of $(N - 1)$-component IFW with cyclic frequencies $\Omega$, $2\Omega$, ...., $(N - 1)\Omega$ formed by parametric radiating antenna by turning-off or antiphase connection of given constituents set of $N$ pump waves spectral components is performed.

It is preferably to implement the adjustment of generation efficiency and correction of parameters of the first component field of IFW with cyclical frequency $\Omega$ by antiphase connection in relation to the rest central constituents of $N$ pump waves spectral components.

In the optimal way adjustment of generation efficiency and correction of parameters of the second component field of IFW with cyclical frequency $2\Omega$ should be implemented by antiphase connection of central constituents of $N$ pump waves spectral components in relation to the rest, e.g. six-components pumping signal requires spectral components number 3 and 4 with negative amplitudes, keeping positive amplitude of components number 1,2,5,6.

In the optimal way adjustment of generation efficiency and correction of parameters of the third component field of IFW with cyclical frequency $3\Omega$ should be implemented by simultaneous antiphase connection of groups' constituents of $N$ pump waves spectral components in relation to the rest, e.g. six-components pumping signal requires spectral components number 1, 2 and 3 with positive amplitudes and 4, 5 and 6 with negative amplitude.

It is preferably to form IFW with cyclic frequencies $\Omega$, $2\Omega$, ...., $(N - 1)\Omega$ components taking into account quadratic non-linearity of location medium and values of its properties, i.e. non-linear parameter $\varepsilon$, density $\rho_0$, sound velocity $c_0$ and attenuation constant $\alpha_{v\omega}$ and $\alpha_{(N-1)\Omega}$ of multicomponent pump waves and intercarrier frequencies providing time and spatial coordination of intense ultrasound pump waves.

It is preferably to use electroacoustic transducer that has given quantity of piezoelements forming aperture.

It is preferably to use piezoelement made of piezoceramic shaped as bar with resonant size $l_{bar} = c_{bar}/2f_0$, where $c_{CT}$ is sound velocity in the bar, $f_0$ is its oscillations resonance frequency.

This problem is solved by device to implement the method; the device has reference generator, delayed pulse-shaping circuit, $(N - 1)$ coincidence circuit, $N$ frequency dividers, analog switch, adder, amplitude modulator, impulse generator, power amplifier, electroacoustic transducer, controlling and adjustment unit and the first reference generator output is connected via delayed pulse-shaping circuit with the second coincidence circuits inputs, outputs of which are connected via frequency dividers with $N$ analog switch signal inputs; and coincidence circuits and dividers often form $(N - 1)$ switched on in parallel links, coincidence circuits outputs of previous links are connected with the first coincidence circuits inputs of following links, the first signal analog switch output is connected via frequency divider with reference generator output, connected with coincidence circuit input of the first link of $(N - 1)$ coincidence circuits, analog switch output via adder, amplitude modulator and power amplifier connected with electroacoustic transducer input, amplitude modulator control input is connected with impulse generator control output, analog switch control input is connected with the second controlling and adjustment unit output and its first and third outputs are connected respectively with reference generators and impulse generator control inputs.

Electroacoustic transducer has piezoelement and shielding, hydro, electro and noise reduction elements.

Claimed method and device have the same inventive conception and allow to solve technical problem of generation efficiency improvement and performance upgrade due to creation in PRA driver circuit of electric multicomponent oscillation signal, which is presented as sum of $N$ oscillations causing distribution of $N$ component pump wave in aquatic medium.

**BRIEF DESCRIPTION OF THE DRAWINGS**

Claimed method and device is illustrated by the following drawings.

**Fig. 1** presents flow diagram of device to implement the method;
**Fig. 2** presents diagram of electric tension in device;
**Fig. 3** and **4** present time shape and corresponding spectrum for multicomponent pump signal (at $N = 5$);
**Fig. 5** presents experimental chart of PRA efficiency change from the figure $N$ of used spectral components in multicomponent pumping signal;
**Fig. 6** presents experimental axial distribution of levels of IFW first component sound pressure $F\_ = 16,5$ kHz for different sets of spectral components in pumping signal: curve 1 stands for six phased components, curve 2 stands for two unphased components (method of initial beating);
**Fig.7** presents experimental axial distribution of levels of IFW sound pressure components $F\_ = 16,5$ kHz, 2 $F\_ = 33$ kHz, 3 $F\_ = 49,5$ kHz, 4 $F\_ = 66$ kHz, 5 $F\_ = 82,5$ kHz (curves 1 - 5 respectively) for six-component pumping signal;
**Fig. 8** presents experimental angle distribution of levels of IFW first component sound pressure $F\_ = 16,5$ kHz at phased six-component pumping signal (curve 1) and two unphased components (method of initial beating, curve 2);

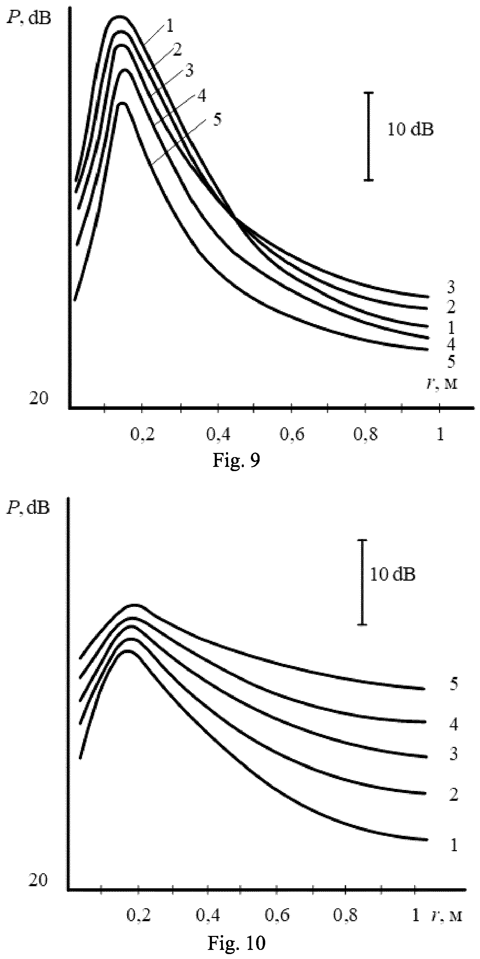

**Fig. 9** and **10** represents information for comparing experiment results, in particular, two sets of axial distribution of levels of IFW sound pressure are presented, generated PRA at different forming modes of pumping signal components and other equal conditions: fig. 9 shows six phased components (claimed method) of IFW $F\_ = 16,5$ kHz, 2 $F\_ = 33$ kHz, 3 $F\_ = 49,5$ kHz, 4 $F\_ = 66$ kHz, 5 $F\_ = 82,5$ kHz (curves 1-5 respectively), fig. 10 shows two unphased components (method of initial beating), IFW $F\_ = 16,5$ kHz, 2 $F\_ = 33$ kHz, 3 $F\_ = 49,5$ kHz, 4 $F\_ = 66$ kHz and 5 $F\_ = 82,5$ kHz (curves 1 - 5 relatively);
**Fig.11** presents two diagrams illustrating IFW component attenuation degree $F\_ = 16,5$ kHz for phased six-component pumping signal from number $N$ of so-called manipulated spectral component that in the course of experiment either switched off ($f(A)$ - dotted line) or switched on in antiphase ($f(\varphi)$ - solid line);

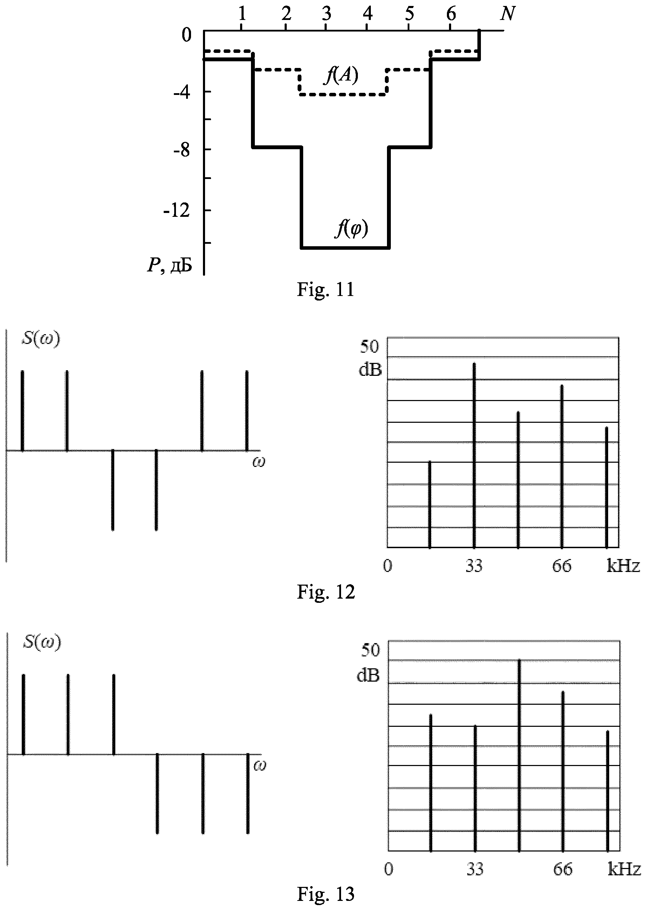

**Fig 12** and **13** presents information illustrating the possibility to both controlling PRA efficiency and correcting IFW forming ultrasound field parameters due to "group" manipulation of six-component pumping signal spectral components: fig. 12 shows pumping signal spectrum $S(\omega)$ (the third and the forth spectral compounds are included in antiphase) and a picture of experimental spectrogram for IFW components in aquatic environment for PRA, fig. 13 shows pumping signal spectrum $S(\omega)$ (the forth, the fifth and the sixth spectral components are included in antiphase) and picture of experimental spectrogram for IFW components in aquatic environment for PRA.

## DETAILED DESCRIPTION OF THE PREFERRED EMBODIMENT

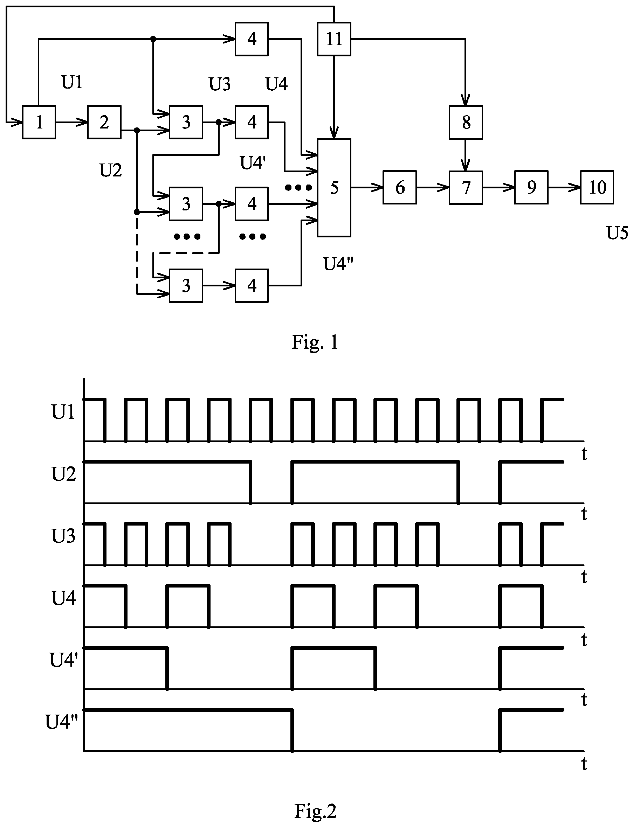

The device for method implication (fig. 1 and 2) contains reference generator 1, the first output of which is connected via delayed pulse-shaping circuit 2 with second coincide circuits' outputs 3, outputs of which are connected via frequency dividers 4 with $N$ analog switch signal inputs 5. Coincidence circuits 3 and frequency dividers 4 form the same quantity of switched on in parallel links and coincidence circuits outputs 3 from previous links are connected with coincidence circuits 3 first inputs from previous links. Reference generator 1 outputs are connected via frequency divider 4 with the first analog switch 5 signal input and with the first coincidence circuit 3 input of the first link. Analog switch 5 output is connected via adder 6, impulse modulator 7, power amplifier 9 with EAT input 10, impulse modulator 7 control input is connected with impulse generator 8 contact output. Controlling and adjustment unit 11 contact outputs are connected with analog switch 5, reference generator 1 and impulse generator 8 controlling inputs.

Adjustment of PRA operation modes can be automatic and manually by operator.

Device operation to implement the method of control IFW PRA efficiency generator is following. Operator commands to launch reference generator 1, producing electric signals $U1$ that are continued sequence of impulses with frequency $f_0$ at given polarity and phase relations, via control and tuning unit 11. To obtain a set of necessary pumping signal component figures and rearrangement simplicity of intercarrier frequency signal, electric signal $U1$ is fed to the first coincidence circuit 3 input, meanwhile electric signal $U2$ is fed from delayed pulse-shaping circuit 2 to coincidence circuit 3 input. Formula for desired spectrum frequency is the following: $F_k = [(m - k)/m] \times F_0$, where $m$ is amount of reference generator 1 impulses, located in carve period and $k$ is the amount of carved impulses; $F_0 = f_0/2^n$, where $f_0$ is reference generator frequency, $2^n$ is scalling ratio, $n$ is amount of halving. The scheme defines pumping signal multi-component spectrum step or intercarrier frequency as $F_- = F_0/m$. Electric signal $U_2$ is fed from delayed pulse-shaping circuit to coincidence circuits 3 second outputs($N$-1), coincidence circuits' 3 outputs of which are connected via frequency divider 4 with analog switch 5 $N$ signal inputs and coincidence schemes 3 and frequency divider 4 form the same amount of switched on in parallel links. Connecting of coincidence circuits 3 first inputs in links switched in in parallel is carried taking into account that scaling of reference generator 1 should be in every link. Thus, coincidence circuits 3 outputs of previous links are connected with coincidence circuits 3 first inputs of following links.

Electric signal $U1$ from reference generator 1 is fed via frequency divider 4 to analog switch first signal input and this signal $U1$ is also fed to coincidence circuit 3 first input from the first link described above. Thus, $N$ oscillations with the same amplitude ($U3,U4,U4,....,U4"$) and with the same initial phase (at the moment of time $t = 0$) to form multi-component excitation signal are fed to $N$ signal inputs of analog switch 5, controlling input of which is connected with control and adjustment unit 11 second output, the first and the third outputs of which are connected with reference generator 1 and impulse generator 8 controlling inputs (this connection allows to choose impulse or continued PRA operation mode). Operator's command 12 is received via controlling and adjustment unit 11 with analog switch 5 controlling input; the command 12 sets amount of oscillations necessary to form given implementation of multicomponent excitation signal. This implementation of electric multicomponent excitation signal S (t)

formed at adder 6 output is presented as sum of $N$ oscillations by the following formula

$$S(t) = \sum_{v=0}^{N-1} \sin(\omega_1 + v\Omega)t = N[\sin(N\Omega t / 2) / N \sin(\Omega t / 2)]\sin \omega_m t$$
,

where $\omega_m = \omega_1 + (N - 1)\Omega/2$ *and* $t = 2\pi/N\Omega = 1/NF_-$, which allows to work with separated $N$ spectral components of excitation signal $S(t)$, i.e. either switch off or switch on in antiphase mode any set of spectral components in radiating tract.

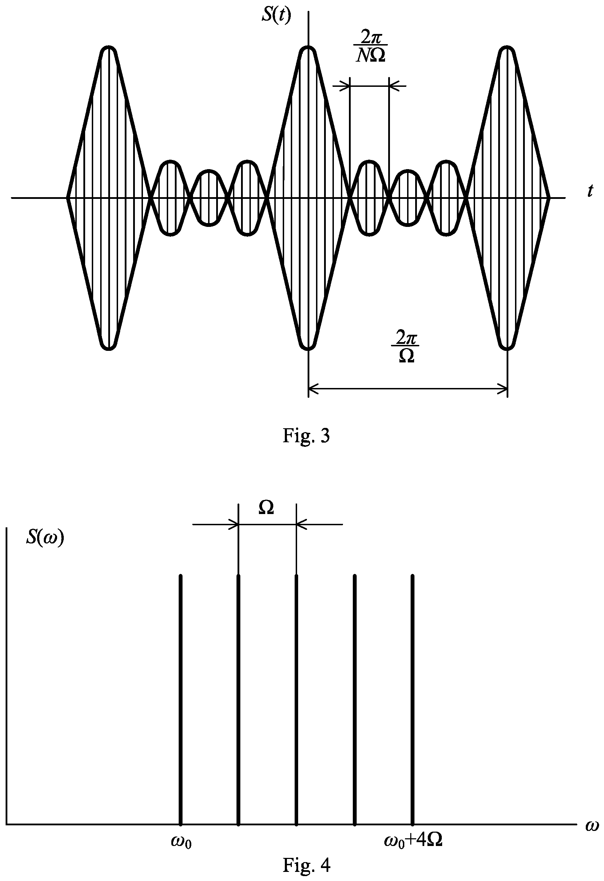

All oscillation are in phase and form maximum when summed when $t = 0$. However, maximum system through time due to its frequency differences is formed, the first zero is registered at the moment of time $t$, defined by equality ($N\Omega t/2$) = $\pi$, where $t = 2\pi/N\Omega = 1/NF_-$. Denominator zeros define the main maximum, beats period is defined by numbers of main maximums at time unit, i.e. denominator zero values, ($\Omega t/2$) = $\pi \cdot n$, where $n$=0, 1, 2, ...., where $t = n/F_-$; $\Delta t = 1/F_-$. Fig 3 and 4 present temporal shape and spectrum for multicomponent pumping signal (when $N$ =5). Fig. 3 shows that five-component signal envelope curve is complicated, its cyclical basic frequency is $2\pi f_0$ main maximums period is $2\pi/\Omega$ and dummy zero period is $2\pi/N\Omega$. Fig 4 shows piezoelement pass band having five spectral components of pumping signal with frequencies $\omega_0, \omega_0 + \Omega, \omega_0 + 2\Omega, \omega_0 + 3\Omega, \omega_0 + 4\Omega$, presence on frequency axe of each equals cyclical IFW $\Omega$. Multicomponent pumping signal is fed from adder 6 output to impulse modulator 7, controlling input of which is connected with controlling output of impulse generator 8. Further, after power amplifier 9 signal is fed to piezoelement of acoustic transducer 10. Operation of electroacoustic transducer 10 is the following. Piezoelement fully consists of piezoceramic that can ba shaped as, for example, bar of resonance size $l_{bar} = c_{bar}/2f$ (CT Ha bar), where $c_{bar}$ (CT Ha bar) is sound velocity in the bar, $f_0$ is resonance frequency of its oscillations ( see Ultrasound. Little encyclopedia. Edited by I.P.Golyamina, Moscow, Soviet Encyclopedia, 1979. 400 pages. Normal oscillations, pp. 237-238, Piezoelement, piezoeffect, pp. 288-289)

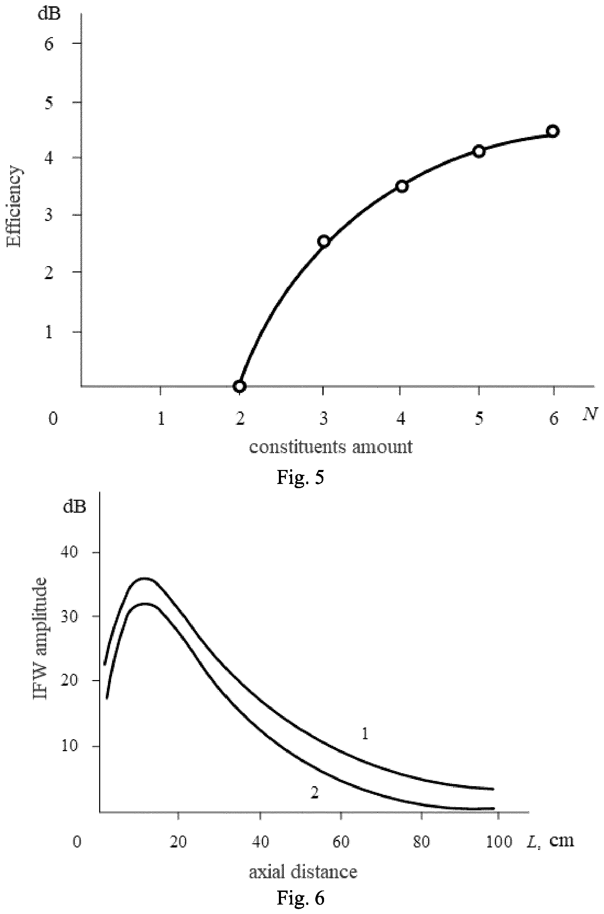

Powerful impulse electric multicomponent excitation signal is fed from radiating tract via hydro, electro and noise reduction elements; this signal's oscillation frequencies can be $\omega_0, \omega_0 + \Omega, \omega_0 + 2\Omega, \omega_0 + 3\Omega, \omega_0 + 4\Omega,...,$ and can be located in half-wave piezoelement pass band, piezoelement because of its characteristics changes its sizes, i.e. oscillates. This oscillations are transmitted to locating area that has non-linear parameter $\varepsilon$, density $\rho_0$, sound velocity $c_0$ and attenuation coefficient $\alpha_{v\omega}$ and $\alpha_{(N-1)\Omega}$ of multicomponent pump waves and intercarrier frequency relatively and distributed as $U5$ impulses containing medium concentration and attenuation. Thus, in medium extended segment, including near and far electroacoustic transducer 10 zones, spatial area of collinear propagation and non-linear interaction of intense pump components with frequencies, for example, $\omega_0, \omega_0 + \Omega, \omega_0 + 2\Omega, \omega_0 + 3\Omega, \omega_0 + 4\Omega,...$ In this way, due to quadratic non-linearity of propagation medium and when both time and spatial coordination of intense pump components are implied, spectral components of combination IFW with frequencies $\Omega, 2\Omega, 3\Omega, 4\Omega, ... ,$ are formed. Multicomponent pump signal $U5$ is presented as a sequence of phased spectral constituents, frequencies of which differs from each other by small quantity of cyclical IFW$\Omega$ and it can be considered as inphase distributed oscillations in the near electroacoustic transducer 10 zone, because $\Omega/\omega_m$ <<1. Inphase distribution of interacting intense pump components is equivalent to energy density increase in volume of PRA, which leads to IFW components amplitude growth and energy density increases with interacting pump components amount growth. Main pump energy transfer is directed to the first IFW$\Omega$ component, which happens because it is generated by the biggest amount of spectral components of multicomponent pump signal, for example, at five-component pump its sources are formed due to four pair of non-linear interaction of components: 1 - 2, 2 - 3, 3 - 4, 4 - 5; for the second IFW $2\Omega$ component - due to three pairs of non-linear interaction of components: 1 - 3, 3 - 5, 2 - 4, etc. This, efficiency increase in generation of combination IFW spectral components with frequencies $\Omega, 2\Omega, 3\Omega, 4\Omega,$ is more significant for a component $\Omega$ with the lowest frequency. Command also controls analog switch 5 through control and adjustment unit 11; analog switch 5 ensures arrival of necessary amount $N$ of used spectral components in given implication of multicomponent pump signal at adder input 6. Fig. 5 presents experimental graph of behaviour in far PRA efficiency zone on the first IFW component from amount $N$ of used spectral compounds in given implication of multicomponent pump signals. Presented graph shows that expansion in the number of pump spectral components leads to efficiency increase of PRA (when $N$ = 3 and 4) and dynamic of efficiency increase of generation at the first IFW component decreases at six-component pumping as transfer to IFW components with higher frequencies takes place. In this way, efficiency control of the first IFW $\Omega$ component for PRA, for example, via control and adjustment unit 11 on operator's command can be carried out.

Options for adjustment IFW $\Omega, 2\Omega, 3\Omega, 4\Omega, ...$ component forming ultrasound field parameters are presented below.

Advantages of proposed method are verified with experimental researches, carried out in laboratory and given as example.

**Example.**

EAT 10 with round flat piezoelement with diameter in 20 mm and resonance frequency 1,98 MHz and pass band 200 kHz was used, which allowed operator during the experiment to use 2-6 spectral constituents (consequently distant from each other at $F_-$ = 16,5 kHz with rigid phase constraint, according to fig. 3 and 4) when multicomponent pump signal for PRA is formed. Fig. 6 presents experimental axial distributions of sound pressure levels for the first IFW harmonic $F_-$ = 16,5 kHz for two given implementation of multicomponent pump signals: curve 1 presents six phased components, curve 2 presents two components (method of initial beating). In both researches radiating average pump signals power, set by operator, didn't change.

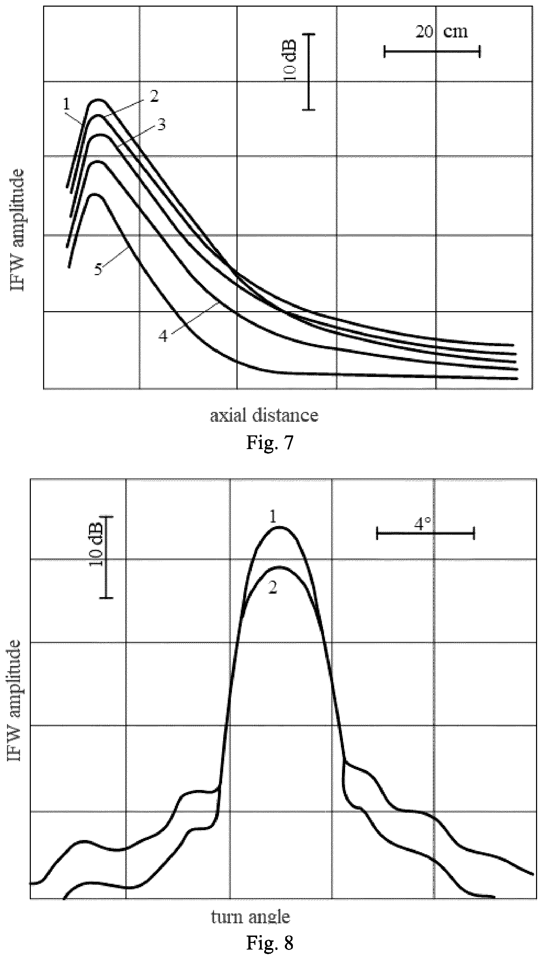

Curves comparison shows that sound pressure level of the first IFW harmonic $F_-$ = 16,5 kHz at EAT 10 axe for six-component signal is 5 dB more that IFW sound pressure level for two-component. Results of measurements conclude that increase of pump wave energy generation efficiency takes place at using multicomponent signal with rigid phase constraint between its constituents. Proposed method allows operator to form in locating area wide band IFW signal that contains low-frequency harmonics, which is useful in some practical applications, for example, to classify aims, detected in hydroacoustic channel. For this purpose, operator generates a command via control and adjustment unit 11 to analog switch 5 controlling input, ensuring necessary amount $N$ =6 of used spectral constituents sent to adder input 6 in given implementation of multicomponent pump signal. Fig 7. shows experimental axial distribution of sound pressure levels of spectral constituents of wide band signal, containing IFW harmonics $F_-$ = 16,5 kHz, 2 $F_-$ =33 kHz, 3 $F_-$ =49,5 kHz, 4 $F_-$ =66 kHz and 5 $F_-$ =82,5 kHz (curves 1 - 5, relatively) for six-component pump signal, measured with hydrophone in far PRA zone. Curves show that all five have maximums of different values (from 64 dB to 54 dB) at the same distance (0,18 m) from electroacoustic transducer 10, and the highest value of maximum corresponds to the first IFW harmonic $F_-$ = 16,5 kHz and the lowest corresponds to the fifth IFW harmonic 5 $F_-$ =82,5 kHz. Physical reason of this dependence is described above. Thus, wide band multicomponent IFW signal is formed as a result of non-linear interaction of six pumping signal spectral constituents, which is important when controlling PRA efficiency and adjusting IFW ultrasound forming field parameters. Mode of aims classification, detected in hydroacoustic channel, assumes the possibility to adjust antenna system angular resolution. Fig. 8 dhows expetimental angular distribution of sound pressure levels for the first IFW harmonic $F_-$ = 16,5 kHz at six-component pumping signal (curve 1) and IFW of the same frequency, obtained at non-linear interaction of two unphased components (method of initial beating, curve 2). Comparison of graphs shows that both main lobe angular width and side field level of PRA with multi-component pumping signal is lower than in two-frequency mode. In this way, there is a possibility to correct IFW forming ultrasound field spatial characteristics.

Fig 9 and 10 show additional information to compare possibilities for operator to correct IFW forming ultrasound field spatial parameters due to the implication of commands via control and adjustment unit 11. It presents results of experimental measurements of groups of two sets of IFW sound pressure levels axial distribution with similar frequencies, generated by PRA at different modes of pumping signal components forming and other equal conditions: - fig.9 presents six phased pump constituents (suggested method, where IFW harmonics $F_-$ = 16,5 kHz, 2 $F_-$ =33 kHz, 3 $F_-$ =49,5 kHz, 4 $F_-$ =66 kHz и 5$F_-$ =82,5 kHz (curves 1 - 5, respectively), fig.10 shows two pump constituents (method of initial beating, IFW $F_-$ = 16,5 kHz, 2 $F_-$ =33 kHz 3 $F_-$ =49,5 kHz, 4 $F_-$ =66 kHz и 5$F_-$ =82,5 kHz (curves 1 - 5, respectively).

Analysis of data given above shows that there is a possibility in accordance with suggested method to generate in locating area IFW wide band multicomponent signal, spectrum of which simultaneously have five IFW harmonics $F_-$ = 16,5 kHz, 2 $F_-$ =33 kHz, 3 $F_-$ =49,5 kHz, 4 $F_-$ =66 kHz и 5 $F_-$ =82,5 kHz (Fig.9, curves 1 - 5, respectively), while at two pump components (two frequencies beating) it is possible to generate in locating area by one narrow band IFW signal the same frequencies (Fig. 10, curves 1- 5 respectively). The differences in amount of interacting spectral constituents in locating area (Fig.9 shows six pump signal constituents, fig.10 shoes two pump signal constituents) leads to, for example, sound pressure IFW level with frequency 16,5 kHz at six-component pumping (fig.9 curve 1) exceeds the same value at two-component pumping (fig.10 curve 1) by 15 dB (near zone) and 6 dB (far zone).

It is also possible to control generation efficiency and adjust IFW $\Omega$first component ultrasound field parameters for PRA due to changing of initial phase and amplitude of six-components pumping signal spectral components on command via controlling and adjustment units 11. Fig 11 presents two diagrams on one field, illustrating attenuation degree of IFW $F_-$ = 16,5 kHz first component level for phased six-component pumping signal from number $N$ spectral component, that during the experiment either switched off ($f(A)$ - dotted line) on switched on in antiphase ($f(\varphi)$ - solid line). Analysis of provided data shows: 1) amplitude of the first component IFW to a large extent depends on spectral constituents antiphase switching on than on its absence in spectrum, for example, absence of the third component causes attenuation of the first IFW component $F_-$ = 16,5 kHz foe 4 dB and antiphase switching on into spectrum attenuates the first IFW harmonic $F_-$ = 16,5 kHz for 14 dB; 2) Implementing this actions by operator 12, i.e. switching off or antiphase switching on of pumping spectral constituents, adjusts level of the first IFW component $F_-$ = 16,5 kHz up to different degrees, actions with side components (the first, the second, the fifth and the sixth) have less influence than actions with central components (the third and the forth) Fig. 12 and 13 provide information illustrating the possibility to control efficiency of IFW$\Omega$ first component generation efficiency and adjusting parameters of forming ultrasound field due to so called group manipulation of six-component pumping signal spectral constituents: fig.12 shows spectrum $S(\omega)$ of multicomponent pumping signal (the third and the forth spectral constituencies are in antiphase) and experimental spectrogram picture foe every IFW component in locating area for PRA, fig. 13 shows spectrum $S(\omega)$ of pumping signal (the forth, the fifth and the sixth spectral components are in antiphase) and a picture of experimental spectrogram for all IFW components in locating area.

Claimed method and device can find wide application in dredging activities, search of silted and flooded subjects, in particular, conduits ay exact profiling and echolocating of the bottom and its layers, contouring enterprises silt emissions and defying its layers thickness, etc. In this conditions, it is relevant to use hydroacoustic signals of diapason of tens-thousands Hz, formed by PRA with increased IFW generation efficiency.

**Claims**

1. The method of intercarrier frequency wave generation efficiency control of parametric radiating antenna is based on:

    placing electroacoustic transduser with a piezoelement having given resonance frequency $(f_1 + f_2)/2 = f_0$ and pass band corresponding to intercarrier frequency wave diapason in locating area,
    inputting electric signals from an output of a radiating tract to the piezoelement of the electroacoustic transducer, the electric signals having amplitudes varying according to a harmonic law and having values of oscillations

frequencies $f_1, f_2$,

spatial area of collinear distribution and non-linear interaction intense ultrasound pump waves, including near and far zones of formed the parametric radiating antenna, is formed in locating medium,

intercarrier frequency wave with cyclic frequency $\Omega = 2\pi \mid f_1 - f_2 \mid$ is generated, is different in the fact that:

forming a multicomponent excitation signal, generating in the radiating tract $N$ oscillations of the same amplitude and with similar initial phase at the moment of time $t = 0$) with frequencies $\omega_v$ sequentially differing from each other by $\Omega = 2\pi F\_$ and located in piezoelement pass band,

feeding from radiating tract to the piezoelement with resonance cyclic frequency $\omega_0 = 2\pi f_0$ an electric multicomponent excitation signal, presents and sum of $N$ oscillations,

generating in locating area spatial domain of collinear distribution and non-linear interaction of intense $N$ component ultrasound pump wave, including near and far zones of forms parametric radiating antenna,

generating in the parametric radiating antenna $(N - 1)$ component intercarries frequency wave with cyclical waves $\Omega$, $2\Omega$, ...., $(N - 1)\Omega$ defined by non-linear interaction in distribution medium of given amount of $N$ pump waves spectral components with cyclical frequencies $\omega_0$, $\omega_1 = \omega_0 + \Omega$, $\omega_2 = \omega_0 + 2\Omega$,... $\omega_v = \omega_0 + N\Omega$, adjustment of generation efficiency and correction of field parameters $(N - 1)$ component intercarrier wave with cyclical frequencies $\Omega$, $2\Omega$, ...., $(N - 1)\Omega$ of formed the parametric radiating antenna is implemented by switching off or on antiphase switching on of given compounds set of $N$ pump wave spectral components.

2. The method according to claim 1, the method is different in the fact of implementing generation efficiency regulation and the correction of the first component field of intercarrier wave frequency with cyclic frequency $\Omega$ by antiphase switching on with respect to the rest central constituents of $N$ pump wave the spectral components.

3. The method according to claim 1, the method is different in the fact of implementing generation efficiency regulation and the correction of the second component field of intercarrier wave frequency with cyclic frequency $2\Omega$ by antiphase switching on central constituents of $N$ pump wave spectral components with respect to the rest, for example, at six-component signal of pumping, the spectral constituents with numbers 3 and 4 with negative amplitudes are used, keeping positive amplitude of constituents 1,2,5 and 6.

4. The method according to claim 1, the method is different in the fact of implementing generation efficiency regulation and the correction of the third component field of intercarrier wave frequency with cyclic frequency $3\Omega$ by antiphase switching on the central constituents of $N$ pump wave spectral components with respect to the rest, for example, at six-component signal of pumping, the spectral constituents with numbers 1,2 and 3 with positive amplitudes are used, keeping negative amplitude of constituents 4,5 and 6.

5. The method according to claim 1, the method is different in the fact of forming intercarrier frequency wave components with frequencies $\Omega$, $2\Omega$, ...., $(N - 1)\Omega$ taking into account quadratic non-linearity of locating medium and values of its properties values, i.e. non-linear parameter $\varepsilon$, density $\rho_0$, sound velocity $c_0$ and attenuation coefficient $\alpha_{v\omega}$ and $\alpha_{(N-1)\Omega}$ of multicomponent pump waves and intercarrier frequency providing time and spatial coordination of intense ultrasound multicomponent pump waves.

6. The method according to claim 1, the method is different in the fact of using electroacoustic transducer containing given amount of piezoelements, forming a radiating aperture.

7. The method according to claim 1, the method is different in the fact of using piezoelement mage of piezoceramic and shaped as a bar of resonance size $l_{bar} = c_{bar}/f_0$, where $c_{bar}$ is sound velocity on the bar, $f_0$ is resonance frequency of its oscillations.

8. The device to implement the method contains reference generator, delayed pulse-shaping circuit, $(N - 1)$ coincidence circuit, $N$ frequency dividers, analog switch, adder, amplitude modulator, impulse generator, power amplifier, electroacoustic transducer, controlling and adjustment unit and the first reference generator output is connected via delayed pulse-shaping circuit with the second coincidence circuits inputs, outputs of which are connected via frequency dividers with $N$ analog switch signal inputs; and coincidence circuits and dividers often form $(N - 1)$ switched on in parallel links, coincidence circuits outputs of previous links are connected with the first coincidence circuits inputs of following links, the first signal analog switch output is connected via frequency divider with reference generator output, connected with coincidence circuit input of the first link of $(N - 1)$ coincidence circuits, analog switch output via adder, amplitude modulator and power amplifier connected with electroacoustic transducer input, amplitude modulator control input is connected with impulse generator control output, analog switch control input is connected with the second controlling and adjustment unit output and its first and third outputs are connected respectively with reference generators and impulse generator control inputs.

9. The device according to claim 8, the device is different in the fact of electroacoustic transducer having the piezoelement and also shielding, hydro, electro and noise reduction elements.

Fig. 1

Fig.2

$S(t)$

$\dfrac{2\pi}{N\Omega}$

$t$

$\dfrac{2\pi}{\Omega}$

Fig. 3

$S(\omega)$

$\Omega$

$\omega$

$\omega_0$ $\omega_0+4\Omega$

Fig. 4

Fig. 5

Fig. 6

axial distance

Fig. 7

turn angle

Fig. 8

Fig. 9

Fig. 10

Fig. 11

Fig. 12

Fig. 13

| INTERNATIONAL SEARCH REPORT | International application No. |
|---|---|
| | PCT/RU 2019/000450 |

| A. | CLASSIFICATION OF SUBJECT MATTER | *H01Q 3/42 (2006.01)* |
|---|---|---|

According to International Patent Classification (IPC) or to both national classification and IPC

| B. | FIELDS SEARCHED |
|---|---|

Minimum documentation searched (classification system followed by classification symbols)

H01Q 3/00-3/42, H01Q 21/00-21/28, G01S 15/00-15/96

Documentation searched other than minimum documentation to the extent that such documents are included in the fields searched

Electronic data base consulted during the international search (name of data base and, where practicable, search terms used)

PatSearch (RUPTO internal), USPTO, PAJ, Esp@cenet, DWPI, EAPATIS, PATENTSCOPE, Information Retrieval System of FIPS

| C. | DOCUMENTS CONSIDERED TO BE RELEVANT | |
|---|---|---|
| Category* | Citation of document, with indication, where appropriate, of the relevant passages | Relevant to claim No. |
| A | US RU 2247409 Cl (BAKHAREV SERGEI ALEKSEEVICH) 27.02.2005 | 1-9 |
| A | A.E. ANISHCHENKO et al. SPOSOB FORMIROVANIA FAZOMANIPULIROVANNYKH SIGNALOV GIDROAKUSTICHESKOI PARAMETRICHESKOI ANTENNOI. IZVESTIA JUFU. TEKHNICHESKIE NAUKI. RAZDEL I. METODY I SREDSTVA AKUSTICHESKOGO MONITORINGA. NUMBER 6(200), 2018, Taganrog, p. 67-75 | 1-9 |
| A | RU 67290 U1 (OAO "KONTSENRN "OKEANPRIBOR") 10.10.2007 | 1-9 |

☐ Further documents are listed in the continuation of Box C.     ☐ See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 08 April 2020 (08.04.2020) | 09 April 2020 (09.04.2020) |

| Name and mailing address of the ISA/ RU | Authorized officer |
|---|---|
| Facsimile No. | Telephone No. |

Form PCT/ISA/210 (second sheet) (January 2015)

**INTERNATIONAL SEARCH REPORT**

| International application No. |
| --- |
| PCT/RU 2019/000450 |

C (Continuation).     DOCUMENTS CONSIDERED TO BE RELEVANT

| Category* | Citation of document, with indication, where appropriate, of the relevant passages | Relevant to claim No. |
| --- | --- | --- |
| A | RU 2550588 C1 (FEDERALNOE GOSUDARSTVENNOE BJUDZHETNOE UCHREZHDENIE NAUKI SPETSIALNOE KONSTRUKTORSKOE BJURO SREDSTV AVTOMATIZATSII MORSKIKH ISSLEDOVANII DALNEVOSTOCHNOGO OTDELENIA ROSSYSKOI AKADEMII NAUK (SKV SAMI DVO RAN)) 10.05.2015 | 1-9 |
| A | RU 179554 U1 (OBSHCHESTVO S OGRANICHENNOI OTVETSTVENNOSTJU "GIDROMARINN") 17.05.2018 | 1-9 |
| A | RU 2550588 C1 (FEDERALNOE GOSUDARSTVENNOE BIUDZHETNOE UCHREZHDENIE NAUKI SPETSIALNOE KONSTRUKTORSKOE BJURO SREDSTV AVTOMATIZATSII MORSKIKH ISSLEDOVANII DALNEVOSTOCHNOGO OTDELENIA ROSSYSKOI AKADEMII NAUK (SKV SAMI DVO RAN)) 10.05.2015 | 1-9 |
| A | RU 2472116 C1 (UCHREZHDENIE ROSSYSKOI AKADEMII NAUK SPETSIALNOE KONSTRUKTORSKOE BJURO SREDSTV AVTOMATIZATSII MORSKIKH ISSLEDOVANII DALNEVOSTOCHNOGO OTDELENIA ROSSYSKOI AKADEMII NAUK (SKV SAMI DVO RAN)) 10.01.2013 | 1-9 |
| A | RU 187455 U1 (OBSHCHESTVO S OGRANICHENNOI OTVETSTVENNOSTJU "GIDROMARINN") 06.03.2019 | 1-9 |
| A | US 9523770 B1 (RUFFA ANTHONY A) 20.12.2016 | 1-9 |

Form PCT/ISA/210 (continuation of second sheet) (January 2015)

**EP 3 989 360 A1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 6704247 B

**Non-patent literature cited in the description**

- Hydroacoustics over 20 years. *80th meeting of the Acoustical Society of America*
- Hydroacoustic over 20 years. materials of 80-anniversary of Acoustic society of the USA. 1975, 176
- New fields of low-frequency hydroacoustic emitters research. *Naval hydroacoustic antennae, §17,* 161-167
- **ZAGRAI N.P.** Non-linear interactions in laminate inhomogeneous mediums. *Taganrog,* 1998, 36-55, 111-217
- Gas-fluid models as of non-linear detergent medium. **KOBELEV Y.A. ; OSTROVSKIY L.A.** Gorkiy. USSR, 1980, 143-160
- **NOVIKOV B.K. ; RUDENKO O.V. ; TIMOSHENKO V.I.** Non-linear hydroacoustic, Leningrad, Shipbuilding. *Signals forming schemes,* 1981, vol. 10 (1), 138-154
- Ultrasound. Little encyclopedia. Soviet Encyclopedia, 1979, 400
- *Normal oscillations,* 237-238
- *Piezoelement, piezoeffect,* 288-289